Europäisches Patentamt

European Patent Office

Office européen des brevets

(11) Veröffentlichungsnummer: **0 145 830**
**B1**

(12) EUROPÄISCHE PATENTSCHRIFT

(45) Veröffentlichungstag der Patentschrift :
09.09.87

(21) Anmeldenummer : **84107010.5**

(22) Anmeldetag : **19.06.84**

(51) Int. Cl.⁴ : **G 01 R 31/28**

(54) Kontaktfeldanordnung für ein rechnergesteuertes Leiterplattenprüfgerät.

(30) Priorität : 07.11.83 DE 3340180

(43) Veröffentlichungstag der Anmeldung :
26.06.85 Patentblatt 85/26

(45) Bekanntmachung des Hinweises auf die Patenterteilung : 09.09.87 Patentblatt 87/37

(84) Benannte Vertragsstaaten :
AT BE CH DE FR GB IT LI LU NL SE

(56) Entgegenhaltungen :
DE-A- 3 110 056
DE-A- 3 240 916
US-A- 4 063 172

(73) Patentinhaber : **MANIA Elektronik Automatisation
Entwicklung und Gerätebau GmbH
Hauptstrasse 86
D-6384 Schmitten 2 (DE)**

**Mang, Paul
Weilbergstrasse 4
D-6384 Schmitten 3 (DE)**

(72) Erfinder : **Mang, Paul
Weilbergstrasse 4
D-6384 Schmitten 3 (DE)**
Erfinder : **Driller, Hubert, Dipl.-Physiker
Altkönigstrasse 11
D-6384 Schmitten 3 (DE)**

(74) Vertreter : **Ruschke, Hans Edvard et al
Patentanwälte Dipl.-Ing. Olaf Ruschke Dipl.-Ing. Hans
E. Ruschke Dipl.-Ing. Jürgen Rost Dipl.-Chem. Dr. U.
Rotter Pienzenauerstrasse 2
D-8000 München 80 (DE)**

EP 0 145 830 B1

## Beschreibung

Es hat sich zunehmend durchgesetzt, industriell gefertigte Leiterplatten elektronisch zu prüfen, um ein zuverlässiges Ergebnis über die Funktionstüchtigkeit einer Leiterplatte zu erhalten, bevor diese weiterverarbeitet wird, d. h. mit Elektronikbauteilen bestückt wird. Bei einer Leiterplatte mit 1 000 Anschlußpunkten sind zur zuverlässigen Prüfung etwa eine halbe Million Prüfungen auf Zweipunkt-Verbindungen nötig, so daß nur die Anwendung elektronischer Prüfverfahren mit Hilfe eines Rechners eine wirtschaftliche Prüfung in vertretbarer Zeit erlaubt. Derartige komputergesteuerte Leiterplattenprüfvorrichtungen werden durch eine einwandfreie, in die Aufnahme für die zu prüfende Leiterplatte eingelegte « Muster »-Leiterplatte programmiert, wobei alle möglichen Kombinationen von Zweipunkt-Verbindungen selbsttätig in das Programm aufgenommen und jede Verbindung auf der Leiterplatte vom Rechner gespeichert wird. Werden anschließend identische Leiterplatten zur Prüfung in die Vorrichtung eingebracht, so findet ein Vergleich jeder einzelnen Zweipunkt-Verbindung mit der Speicherinformation statt, wobei bei fehlender Identität zwischen der gemessenen und der gespeicherten Information eine Fehleranzeige und gegebenenfalls ein Aussortieren der fehlerhaften Leiterplatte stattfindet.

Die Leiterplattenprüfvorrichtung benötigt für jeden möglichen Anschlußpunkt jeder auf der Vorrichtung zu prüfenden Leiterplatte einen Kontaktpunkt, wobei alle diese Kontaktpunkte in einem sogenannten Kontaktfeld oder Grundraster angeordnet werden.

Aus der gattungsbildenden DE-OS-31 10 056 ist eine Kontaktanordnung für ein Leiterplattenprüfgerät mit einer Vielzahl von in einer Kontaktebene angeordneten Kontaktpunkten bekannt. Diese Kontaktpunkte sind in Gruppen von acht Kontakten an der Stirnfläche von langgestreckten, flachen Kontaktplättchen angeordnet, die im wesentlichen die Gestalt eines großen « I » haben und dicht hintereinander gepackt von horizontalen Trägern gehalten einen 8 Kontakte breiten Streifen der Kontaktebene ausbilden. Hierbei dienen die horizontalen Träger zur Ableitung des insgesamt ganz erheblichen Kontaktdruckes. Mehrere solcher Streifen nebeneinander bilden das gesamte Kontaktfeld bzw. Grundraster, welches viele 1 000 Einzelkontakte aufweisen kann. Mit der Aufteilung des Kontaktfeldes in viele solche Kontaktplättchen oder Kontaktfeldabschnitte wird bezweckt, daß ein gegebenenfalls notwendiges Auswechseln eines oder mehrerer Abschnitte nicht dazu führt, daß das gesamte Kontaktfeld ausgebaut werden muß.

Die die Kontaktpunkte an ihrer Stirnseite aufweisenden I-förmigen Kontaktplättchen werden an ihrer vom Kontaktfeld abgewandten Seite mit Anschlußdrähten verbunden, die zur rechnergesteuerten Prüfschaltung des Leiterplattenprüfgerätes führen. Jeder Kontaktpunkt ist mit einem Anschlußdraht verbunden, d. h. an der Unterseite des Kontaktfeldes ist eine Unmenge von Drähten vorhanden, die eine Reperatur oder ein Auswechseln von einzelnen Kontaktplättchen erschwert. Da diese Drähte außerdem an die jeweiligen Bereiche des Kontaktfeldes herangeführt sein müssen, ist ein Verändern des Kontaktfeldes (z. B. in Anpassung an den Umriß einer zu prüfenden Leiterplatte) weder vorgesehen noch praktisch möglich. Außerdem muß das Leiterplattenprüfgerät von vornerein vollständig mit der notwendigen Prüfelektronik ausgerüstet sein, so daß es zur Überprüfung der größtmöglichen Anzahl von Anschlußpunkten einer Leiterplatte in der Lage ist, auch wenn dieser Extremfall bei manchen Anwendern vielleicht nie auftritt.

Es ist daher die Aufgabe der vorliegenden Erfindung, die Kontaktfeldanordnung eines Leiterplattenprüfgerätes derart auszubilden, daß das Kontaktfeld vom Anwender problemlos sowohl nach der Anzahl der benötigten Kontaktpunkte als auch nach deren flächenmäßiger Verteilung innerhalb bestimmter äußerer Maximalgrenzen eingerichtet werden kann. Insbesondere soll der Anwender in die Lage versetzt werden, die für die Überprüfung einer zunehmend größeren Zahl von Leiterplattenanschlußpunkten benötigte zusätzliche Elektronik schrittweise nachrüsten zu können, so daß sein Leiterplattenprüfgerät nur so viel (teure) Elektronik aufweist, wie er tatsächlich benötigt. Es soll also ein Leiterplattenprüfgerät mit einem Kontaktfeld vorgesehen werden, welches je nach Wunsch von einer Mindestzahl aktiver Kontaktpunkte ausgehend bis zu der maximal möglichen Anzahl von Kontaktpunkten erweiterbar und darüber hinaus an die jeweils konkrete Form der zu prüfenden Leiterplatte anpaßbar ist — dies natürlich jeweils nur innerhalb der durch die äußeren Abmessungen des Gerätes bestimmten Obergrenzen.

Diese Aufgabe wird erfindungsgemäß durch die Merkmale des Hauptanspruches gelöst. In dem der Raum auf der Seite der Anschlussleitungen der einzelnen Kontaktfeldabschnitte zur Unterbringung eines Großteils der diesen Kontaktpunkten zugehörigen elektronischen Komponenten und zur Unterbringung von zugehörigen separaten Stützstreben zur Ableitung des auf jeden Kontaktfeldabschnitt entfallenden Kontaktdruckanteils in eine Grundplatte ausgenutzt wird, und die so entstehenden Einheiten (« Kontaktfeldmoduln ») über an ihrem (dem Kontaktfeldabschnitt gegenüberliegenden) Ende vorgesehene Steckverbinder mit der Ansteuerlogik derart verbunden sind, daß alle Moduln beliebig untereinander die Plätze tauschen können, wird eine äußerst variabel einsetzbare und problemlos « aufwärts » nachrüstbare Kontaktfeldanordnung geschaffen. Eine Grundausstattung an derartigen Elementen (nachfolgend Kontaktfeldmodul oder Treiberplatte genannt) wird auf der möglichst groß ausgelegten Grundplatte in der Weise verteilt, wie dies die zu prüfende Leiterplatte erfordert. Die freibleibenden Plätze auf der Grundplatte der Kontaktfeldanordnung werden durch Attrappen besetzt, die keine teure Elektronik enthalten und nur zur Aufnahme eines Teils des beim Testen der Leiterplaten anfallenden Kontaktdruckes dienen (können).

Unter Bezugnahme auf die beigefügte prinzipiellen Zeichnungen wird der schematische Aufbau eines Ausführungsbeispiels der vorliegenden Erfindung beschrieben. In diesen zeigt :

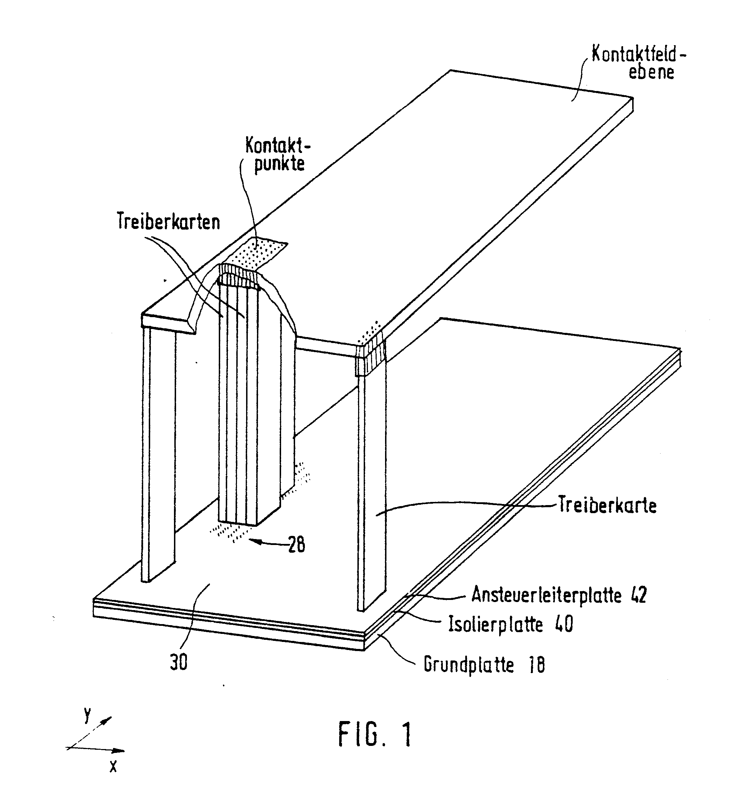

Figur 1 eine perspektivische Gesamtansicht der Kontaktfeldanordnung mit der vollständigen Grundplatte, einigen Kontaktfeldmoduln und der angedeuteten Kontaktfeldebene — die übrigen Teile der Leiterplattenprüfvorrichtung sind nicht gezeigt ;

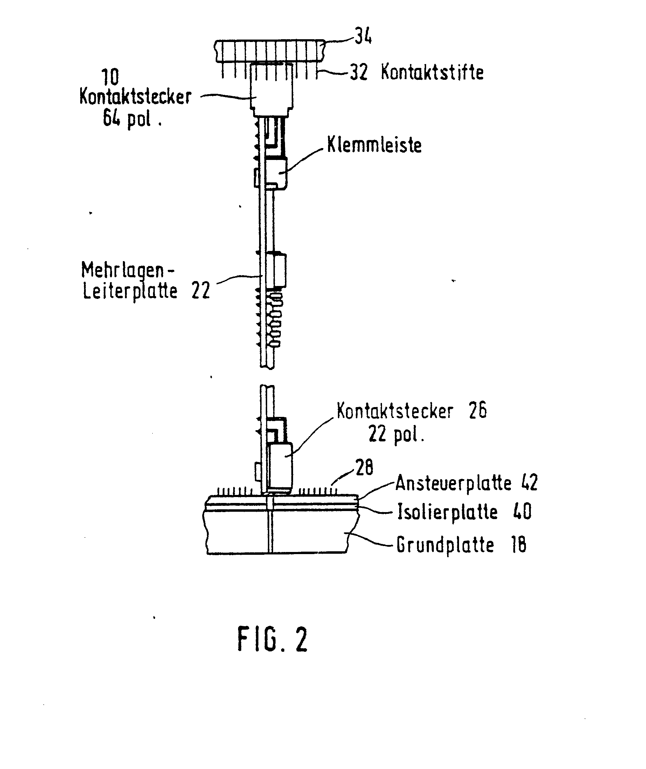

Figur 2 einen Schnitt in vertikaler Richtung durch ein Kontaktfeldmodul, wobei ein Teil der Kontaktfeldebene und die Grundplatte angedeutet ist ; und

Figur 3 ein Kontaktfeldmodul/Treiberplatte in perspektivischer Darstellung.

Für die Zwecke der nachfolgenden Beschreibung wird von einem Ausführungsbeispiel ausgegangen, welches ein Kontaktfeld aufweist, das z. B. für maximal 8 192 Kontaktpunkte vorgesehen ist, d. h. ein rechteckiges Kontaktfeld mit Platz für 128 Kontaktpunkte in Längsrichtung und 64 Kontaktpunkte in Querrichtung (X- bzw. Y-Richtung). Dieses Kontaktfeld wird von nebeneinander angeordneten, in der Draufsicht beispielsweise rechteckigen Kontaktfeldabschnitten oder Kontaktsteckern aufgebaut, die jeweils 64 Einzelkontakte umfassen, nämlich 16 in Längsrichtung und 4 in Querrichtung. Auf der Grundplatte 18 sind also insgesamt 128 Plätze für einzelne Kontaktfeldmoduln/Treiberplatten vorgesehen, d. h. 8 Plätze in Längsrichtung und 16 Plätze in Querrichtung. Wesentlich ist, daß alle Kontaktfeldmoduln identisch aufgebaut sind und an einem beliebigen der angesprochenen 128 Plätze eingesteckt werden können. Es sei jedoch darauf verwiesen, daß ein typisches übliches Kontaktfeld beispielsweise 256 × 256 Kontaktpunkte in der X- bzw. Y-Richtung der Kontaktfeldebene besitzt, d. h. insgesamt 65 536 Einzelkontakte.

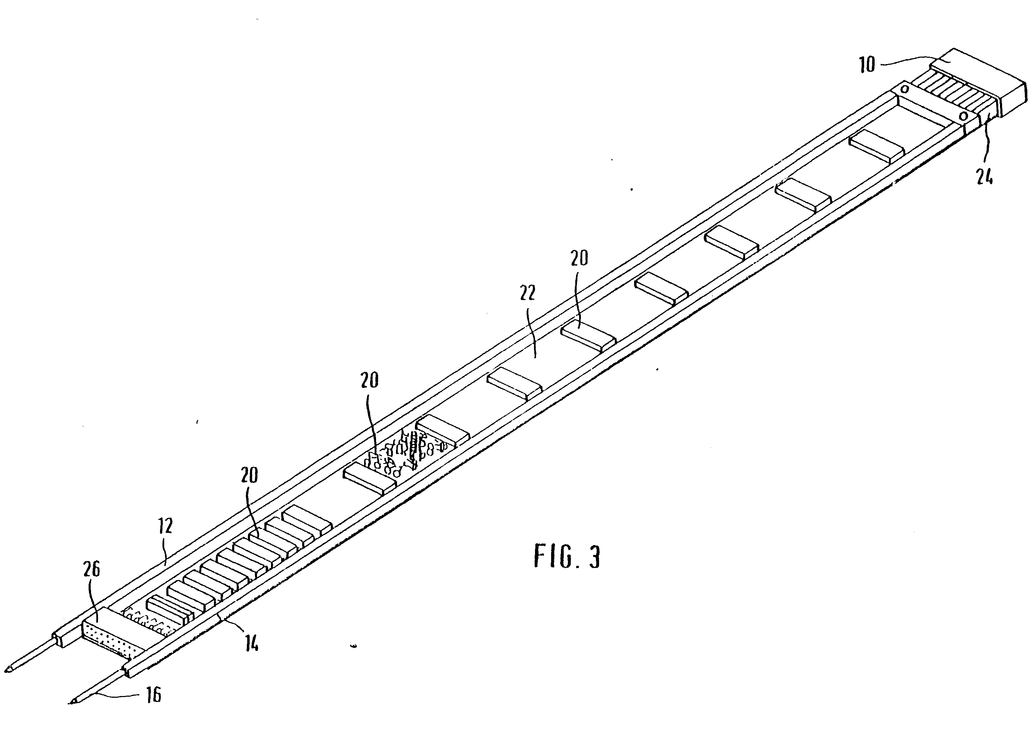

Jedes Kontaktfeldmodul, wie es in perspektivischer Darstellung in Fig. 3 gezeigt ist, weist einen oberen Kontaktstekker 10 auf, der in (oder zumindest in der Nähe) der Kontaktebene von zwei langen, senkrecht nach unten verlaufenden stützstreben 12, 14 aus z. B. Aluminium abgestützt wird. Diese Stangen haben ein quadratisches Profil und sind an ihrem unteren Ende auf einen im Querschnitt kreisrunden zapfen 16 abgedreht, welcher in eine entsprechende Bohrung in der Grundplatte 18 aus Metall, z. B. Aluminium, einsetzbar ist. Da beim Prüfen von Leiterplatten zur Erzeugung eines zuverlässigen Kontaktes ein erheblicher Kontaktdruck erzeugt werden muß (beispielsweise 300 p/Kontakt), ergibt sich bei z. B. 8 192 Kontakten ein von allen Kontaktsteckern/Kontaktfeldmoduln aufzunehmender Druck in Höhe von ca. 2,5 t. Dieser von den Kontaktsteckern maximal aufzunehmende Druck wird über die erwähnten langen Stützstreben 12, 14 in die Grundplatte 18 abgeleitet, die in geeigneter Weise im Rahmen der nicht näher dargestellten Leiterplattenprüfvorrichtung gelagert ist. Der Raum senkrecht unterhalb des in der Kontaktebene betrachtet (beispielsweise) rechteckigen Umrisses jedes Kontaktsteckers 10 wird im übrigen dazu ausgenutzt, einen großen Teil der zugeordneten elektronischen Bauteile 20 der Leiterplattenprüfvorrichtung unterzubringen. Dies geschieht mit Hilfe einer mehrlagigen Leiterplatte 22, die an ihrem oberen Ende mit den einzelnen Polen des Kontaktsteckers 10 über geeignete Zuleitungen 24 verlötet ist und im übrigen an den langgestreckten Stützstreben 12, 14 befestigt ist. Der zur Aufnahme der Elektronikbauteile auf diese Weise zur Verfügung stehende Raum ist trotz seiner im horizontalen Schnitt begrenzten Ausmaße, die der an der Kontaktebene gelegenen Stirnfläche des Kontaktsteckers 10 entsprechen, nicht beschränkt, weil er senkrecht zur Kontaktebene an sich beliebig vergrößerbar ist, d. h. die Leiterplatte 22 zur Aufnahme der Elektronikbauteile 20 kann so lang wie notwendig gemacht werden, um alle erforderlichen Bauteile aufzunehmen. Durch eine hochintegrierte Schaltung kann jedoch die Packungsdichte der Elektronikbauteile sehr groß gemacht werden, so daß der Raumbedarf in der senkrechten Richtung auf praktisch gut handhabbare Größen beschränkt bleibt.

Am unteren Ende der Leiterplatte ist im dargestellten Ausführungsbeispiel ein 22 poliger Kontaktstecker 26 vorgesehen, dessen Kontakte seinerseits wiederum mit den verschiedenen Leiterbahnen am unteren Ende der mehrlagigen Leiterplatte verlötet sind. Dieser Kontaktstecker 26 ist dazu vorgesehen, die senkrecht aufragenden Kontaktstifte 28 einer Grundmatrixplatte 30 zu kontaktieren, die auf der Grundplatte 18 aufliegend angeordnet ist und durch die die Stangen der Stützstreben 12, 14 hindurchgeführt sind. Die Grundmatrixplatte (Moduln-Ansteuerplatte) 30 ist mit Hilfe einer geeigneten gedruckten Schaltung dazu vorgesehen, mittels eines zweidimensionalen Addressierungsverfahrens bzw. mit Hilfe einer zweidimensionalen Auswahllogik die verschiedenen auf der Grundmatrixplatte an beliebigen Plätzen aufgesetzten Kontaktfeldmoduln/Treiberplatten anzusteuern.

Der obere Kontaktstecker 10 dient zur Aufnahme von (im Ausführunsbeispiel) 64 Tulpen- oder Pilz-förmigen Kontaktstiften 32 aus einem harten verschleißfestem Werkstoff wie Stahl etc. Der untere Teil des stielförmigen Abschnittes dieser Kontaktstifte sitzt derart in Kontaktstecker, daß eine elektrische Verbindung zur jeweils einem der 64 Pole hergestellt wird. Der obere Abschnitt wird von einer rasterförmigen Lochplatte 34 aufgenommen, wobei diese derart dimensioniert ist, daß sie mehrere (z. B. vier) Kontaktstecker 32 (Kontaktfeldabschnitte) überdeckt. Die « Hüte » dieser von den Lochplatten gehalterten Kontaktstifte bilden die einzelnen Kontaktpunkte der Kontaktfeldebene und durch die Ausgestaltung der einzelnen Kontaktpunkte als Teil von ohne weiteres auswechselbaren verschleißfesten Kontaktstiften wird eine besondere Wartungsfreundlichkeit der Kontaktfeldanordnung erreicht.

Wie sich aus den obigen Ausführungen ergibt, wird die aus dem oberen und unteren Kontaktstecker 10 bzw. 26 sowie den zwei Stützstreben 12, 14 mit der darauf angeordneten Leiterplatte 22 und den Elektronikelementen 20 bestehende Einheit als Kontaktfeldmodul oder Treiberplatte bezeichnet. Deren Umriß in einer Schnittebene parallel zur Kontaktebene ist durch den Umriß des oberen Kontaktsteckers 10 an der Kontaktebene bestimmt, aber die Höhe dieser Einheit ist in der senkrechten Richtung grundsätzlich freidimensionierbar. Jedes einzelne Kontaktfeldmodul ist an einem beliebigen der mit Bezug auf das Ausführungsbeispiel angesprochenen 128 Plätze der Grundplatte 30 bzw. der Grundmatrixplatte 42 einsteckbar und aufgrund der mechanischen Ausgestaltung dazu geeignet, den auf seine Stirnfläche ausgeübten bzw. entfallenden Kontaktdruck über die eigenen Stützstreben an die Grundplatte 18 weiterzuleiten, ohne den unteren Kontaktstecker 26 oder die Grundmatrixplatte 42 (Ansteuerplatte) mechanisch zu belasten.

Durch die dargestellte Aufteilung der Kontaktebene und die Unterbringung des wesentlichsten Teils der zu den jeweiligen Kontaktfeldabschnitten gehörenden Elektronik im Raum unmittelbar darunter in den lastaufnahmefähigen einsteckbaren Treiberplatten oder Kontaktfeldmoduln wird der Käufer einer Leiterplattenprüfvorrichtung in die Lage versetzt, nur so viele teure Elektronik kaufen zu müssen, wie er für die von ihm beabsichtigten Prüfaufgaben benötigt. Die durch diese aktiven Treiberplatten oder Kontaktfeldmoduln nicht belegten Plätze auf der Grundmatrixplatte bzw. auf der die mechanischen Kräfte auffangenden Grundplatte 18 werden durch Attrappen besetzt, d. h. inaktive Kontaktfeldmoduln oder Treiberplatten, die äußerlich die gleiche Gestalt und mechanisch die gleichen Eigenschaften wie die aktiven Treiberplatten haben, aber ohne die kostenaufwendige Elektronik ausgestattet sind.

Der erwähnte Einsparungseffekt wird noch dadurch begünstigt, daß es mit einer gegebenen Anzahl von aktiven Treiberplatten gelingt, verschiedene Leiterplattenformen zu testen, da die aktiven Treiberplatten und die Attrappen sich mit wenigen Handgriffen an neue Leiterplattenformen anpassen lassen, d. h. in einem bestimmten Bereich nicht erforderliche Treiberplatten werden mit wenigen Handgriffen dorthin versetzt, wo sie benötigt werden. Durch die Erfindung wird die Möglichkeit geschaffen, ein Leiterplattenprüfgerät zu schaffen, das vom Konzept her die Möglichkeit von sehr umfangreichen bzw. großen Kontaktfeldern umfaßt, ohne daß die dafür erforderliche Elektronik gleich vollständig mitgekauft werden muß. Gleichzeitig kann die bereits in den Kontaktfeldmoduln vorhandene Elektronik optimal eingesetzt werden, da sie ohne weiteres in Anpassung an verschiedene Leiterplattenformen innerhalb der Maximalgrenzen der Grundplatte umsteckbar ist.

**Patentansprüche**

1. Kontaktfeldanordnung für ein rechnergesteuertes Leiterplattenprüfgerät, mit einer Vielzahl von in der Kontaktfeldebene angeordneten Kontaktpunkten, von denen jeweils mehrere in einem Kontaktfeldabschnitt zu einem einheitlichen Bauteil zusammengefaßt sind, dessen Anschlußleitungen in Richtung der dem Kontaktfeldabschnitt gegenüberliegenden Bauteilseite herausgeführt sind, und in der eine Anzahl identischer Bauteile das Kontaktfeld ausbildet, wobei die Bauteile von Tragteilen im Leiterplattenprüfgerät gegen den aufzubringenden Kontaktdruck abgestützt sind, dadurch gekennzeichnet, daß jeder Kontaktfeldabschnitt mindestens eine ihm zugeordnete Stützstrebe (12, 14) aufweist, welche im Raum auf einer Seite angrenzend an den in der Kontaktfeldebene gelegenen Umriss des zugehörigen Kontaktfeldabschnittes zur dem Kontaktfeldabschnitt gegenüberliegenden Bauteilseite weiter verläuft und lösbar in einer Grundplatte (18) abgestützt ist, daß der durch den Umriß des Kontaktfeldabschnittes und die Länge der Stützstrebe (12, 14) bestimmte Raum die den Kontaktpunkten des Kontaktfeldabschnittes zugeordneten elektronischen Komponenten (20) des Rechners aufnimmt und daß diese Komponenten (20) über einen am der Kontaktfeldebene gegenüberliegenden Ende des Raumes vorgesehenen Steckverbinder (26) mit der Ansteuerlogik des Rechners verbindbar sind.

2. Kontaktfeldanordnung nach Anspruch 1, dadurch gekennzeichnet, daß die elektronischen Komponenten (20) eines jeden Kontaktfeldabschnittes auf einer Mehrlagen-Leiterplatte (22) angeordnet sind, die die elektrischen Verbindungen zwischen den Komponenten (20) aufweist, und daß die Leiterplatte (22) an der oder den Stützstreben (12, 14) befestigt ist.

3. Kontaktfeldanordnung nach einem der Ansprüche 1 oder 2, dadurch gekennzeichnet, daß jeder Kontaktfeldabschnitt von einem am Kontaktfeldabschnitt angrenzenden Ende der Stützstreben (12, 14) angeordneten mehrpoligen Steckverbinder (10) gebildet wird, der dem Umriß des Kontaktfeldabschnittes entspricht und zur Aufnahme des Stiels von auswechselbaren, pilz- oder tulpenförmigen Kontaktstiften (32) vorgesehen ist, deren Hut die Kontaktpunkte des Kontaktfeldes ausbilden.

4. Kontaktfeldanordnung nach Anpruch 3, dadurch gekennzeichnet, daß die Kontaktstifte (32) mehrerer Kontaktfeldabschnitte oder Steckverbinder von einer Raster-Lochplatte (34) zusammengefaßt sind.

5. Kontaktfeldanordnung nach einem der vorstehenden Ansprüche, dadurch gekennzeichnet, daß die Stützstreben (12, 14) eines jeden Kontaktfeldabschnittes die Form von langen Stangen mit quadratischem Profil haben, die jenseits des am der Kontaktfeldebene gegenüberliegenden Ende des Raumes angeordneten Steckverbinders (26) einen Abschnitt (16) reduzierter Stärke aufweisen, welcher in entsprechend gestaltete Öffnungen in der Grundplatte (18) einsteckbar und zur Aufnahme und Weiterleitung des auf den Kontaktfeldabschnitt ausgeübten Kontaktdruckes an die Grundplatte eingerichtet ist.

6. Kontaktfeldanordnung nach Anspruch 1, dadurch gekennzeichnet, daß der am der Kontaktfeldebene gegenüberliegenden Ende des Raumes vorgesehene Steckverbinder (26) in einer solchen Höhe über der Grundplatte (18) angeordnet ist, daß dieser Steckverbinder (26) auch bei aufgebrachtem Kontaktdruck drucklos bleibt.

7. Kontaktfeldanordnung nach einem der Ansprüche, 5 oder 6 dadurch gekennzeichnet, daß die Grundplatte (18) mit einem Raster von senkrecht zur Oberfläche verlaufenden Bohrungen versehen ist, in die die reduzierten Endabschnitte (16) der Stützstreben (12, 14) formschlüssig einpassen. ·

8. Kontaktfeldanordnung nach einem der voranstehenden Ansprüche, dadurch gekennzeichnet, daß jeder Kontaktfeldabschnitt über seine ihm zugeordnete Stützstreben auf der Grundplatte (18) abgestützt ist, auf der, gegebenenfalls mit dazwischenliegender Isolierplatte (40), eine Ansteuerleiterplatte (Grundmatrix platte) (42) angeordnet ist, die Teil der Ansteuerlogik des Rechners ist und mit aufragenden Kontaktstiften (28) zum drucklosen Anschluß an den rechnerseitigen, dem Kontaktfeldabschnitt gegenüberliegenden Steckverbinder (26) eines jeden Kontaktfeldmoduls versehen ist.

**Claims**

1. Contact array assembly for computer-controlled printed circuit board test apparatus, comprising a multiplicity of contact pluralities of which are combined each in a contact array segment forming a unitary module of which the connection wires are taken out in the direction of the module side opposite the contact array segment, with a plurality of identical ones of such modules forming the contact array, and with the modules being supported by load-bearings members in the printed circuit board testing apparatus against the contact pressures to be applied, characterized by each contact array segment having at least one supporting rod (12, 14) associated therewith which extends in the space adjacent the contours, taken in the contact array plane, of the associated contact array segment towards the module side opposite that contact array segment to be supported releasably in a base (18), by the space defined by the contours of the contact array segment and the length of supporting rod (12, 14) accommodating the electronic components (20) of the computer which are associated with the contacts in the respective contact array segment, and by components (20) being adapted to be coupled to the controlling computer logic through a plug-in connector (26) provided at the end of said space opposite the contact array plane.

2. Contact array assembly as in claim 1, characterized in that electronic components (20) of each contact array segment are disposed on a multi-layer printed circuit card (22) with electrical conductors extending between components (20), and in that circuit card (22) is secured to supporting rod or rods (12, 14).

3. Contact array assembly as in any one of claims 1 or 2, characterized by each contact array segment being formed by a multi-pole plug-in connector (10) located at the end of supporting rods (12, 14) adjacent the contact array segment, said connector conforming with the contours of the contact array segment and being adapted to receive the shank portion of replaceable mushroom- or tulip-shaped contact pins (32) of which the hats form the contacts of the contact array.

4. Contact array assembly as in claim 3, characterized by contact pins (32) of a plurality of contact array segments or connectors being grouped together by a board (34) having therethrough perforations on a grid.

5. Contact array assembly as in any one of the preceding claims, characterized by supporting rods (12, 14) of each contact array segment being in the form of elongated rods of square cross section and having below plug-in connector (26) at the end of said space opposite the contact array plane reduced-diameter portions (16) adapted to engage complementary openings in base plate (18) to receive and transmit to the base plate the contact pressure acting on the contact array segment during testing.

6. Contact array assembly as in claim 1, characterized in that plug-in connector (26) at the end of said space opposite the contact array plane is positioned at a height above base plate (18) such that connector (26) remains unloaded even when contact pressure is applied.

7. Contact array assembly as in any one of claims 5 or 6, characterized by base plate (18) being provided with a grid oof openings normal to the surface thereof and adapted to receive the reduced-diameter portions (16) of supporting rods (12, 14) in a shape-locked manner.

8. Contact array assembly as in any one of the preceding claims, characterized in that each contact array segment is supported on base plate (18) by the associated supporting rods and that base plate (18) has thereon — optionally on an intervening insulating board (40) — a module control board (basic grid board) (42) which is a part of the controlling computer logic and has upstanding contact pins (28) thereon for pressure-free connection to connector (26) opposite the contact array segment for coupling each contact array module to the computer.

**Revendications**

1. Agencement de groupement de contacts pour un appareil de vérification de cartes de circuits commandé par processeur, avec une multiplicité de points de contact agencés dans le plan de groupement de contacts, dont plusieurs sont à chaque fois réunis dans une section de groupement de contacts en un composant homogène, dont les conducteurs de connexion sont sortis dans la direction de la face du composant opposée à la section de groupement de contacts, et dans lequel un certain nombre de composants identiques constitue le groupement de contacts, les composants étant soutenus par des pièces de support dans l'appareil de vérification de cartes de circuits à l'encontre de la pression de contact à appliquer, caractérisé en ce que chaque section de groupement de contacts présente au moins un élément d'appui (12, 14) lui associé, qui s'étend dans l'espace limitrophe sur un côté du contour situé dans le plan de groupement de contacts, de la section de groupement de contacts associée, vers la face du composant opposée à la section de groupement de contacts et est soutenu de manière libérable dans une plaque de base (18), en ce que le volume déterminé par le contour de la section de groupement de contacts et la longueur des éléments d'appui (12, 14), reçoit les composants électroniques (20) du processeur associés aux points de contact de la section de groupement de contacts, et en ce que ces composants (20) peuvent être reliés, par l'intermédiaire d'un connecteur à enficher (26) prévu à l'extrémité du volume opposée au plan de groupement de contacts, à la logique de commande du processeur.

2. Agencement de groupement de contacts suivant la revendication 1, caractérisé en ce que les composants électroniques (20) de chaque section de groupement de contacts sont agencés sur une carte de circuits multicouche (22), qui présente les liaisons électriques entre les composants (20), et en ce que la carte de circuits (22) est fixée à l'élément ou aux éléments d'appui (12, 14).

3. Agencement de groupement de contacts suivant une des revendications 1 ou 2, caractérisé en ce que chaque section de groupement de contacts est formée par un connecteur à enficher (10) multipolaire agencé à l'extrémité limitrophe de la section de groupement de contacts des éléments d'appui (12, 14), qui correspond au contour de la section de groupement de contacts et est prévu pour recevoir la tige de broches de contact remplaçables (32), en forme de tulipe ou champignon, dont les chapeaux forment les points de contact du groupement de contacts.

4. Agencement de groupement de contacts suivant la revendication 3, caractérisé en ce que les broches de contact (32) de plusieurs sections de groupement de contacts ou connecteurs à enficher sont réunies par une plaque perforée de trame (34).

5. Agencement de groupement de contacts suivant l'une des revendications précédentes, caractérisé en ce que les éléments d'appui (12, 14) d'une section de groupement de contacts ont la forme de longues barres de profil carré qui présentent au-delà du connecteur à enficher (26) agencé à l'extrémité opposée au plan de groupement de contacts du volume, une section (16) d'épaisseur réduite, qui peut être enfichée dans des ouvertures de configuration correspondante dans la plaque de base (18) et est conçue pour recevoir et transmettre à la plaque de base la pression de contact exercée sur la section de groupement de contacts.

6. Agencement de groupement de contacts suivant la revendication 1, caractérisé en ce que le connecteur à enficher (26) prévu à l'extrémité opposée au plan de groupement de contacts du volume, est agencé à une hauteur telle au-dessus de la plaque de base (18), que ce connecteur à enficher (26) reste sans pression même avec la pression de contact appliquée.

7. Agencement de groupement de contacts suivant une des revendications 5 ou 6, caractérisé en ce que la plaque de base (18) est dotée d'une trame d'alésages s'étendant perpendiculairement à la surface, dans lesquels s'adaptent à liaison de forme les sections d'extrémité (16) des éléments d'appui (12, 14).

8. Agencement de groupement de contacts suivant l'une des revendications précédentes, caractérisé en ce que chaque section de groupement de contacts est soutenue par l'intermédiaire des éléments d'appui lui associés, sur la plaque de base, sur laquelle est agencée, éventuellement avec une plaque isolante interposée (40), une carte de circuits de commande (plaque de matrice de base) (42), qui fait partie de la logique de commande du processeur et est dotée de broches de contact en saillie (28) pour une connexion sans pression avec le connecteur à enficher (26) côté processeur, opposé à la section de groupement de contacts, de chaque module de groupement de contacts.

Kontaktfeldebene

Kontaktpunkte

Treiberkarten

Treiberkarte

Ansteuerleiterplatte 42

Isolierplatte 40

Grundplatte 18

28

30

FIG. 1

34

32 Kontaktstifte

10
Kontaktstecker
64 pol.

Klemmleiste

Mehrlagen-
Leiterplatte 22

Kontaktstecker 26
22 pol.

28
Ansteuerplatte 42
Isolierplatte 40
Grundplatte 18

# FIG. 2

FIG. 3

0 145 830